# EUROPEAN PATENT APPLICATION

(11) **EP 0 845 546 A2**
(43) Date of publication of application: **03.06.1998**
(21) Application number: 97307402.4
(22) Date of filing: 23.09.1997
(51) Int. Cl.: C23C 16/46, C23C 16/24, H01L 21/3205

(54) **A warm wall reaction chamber and a method for forming a hemi-spherical grain layer using the same**

(30) Priority: 30.11.1996 KR 9660521
(71) Applicant: Samsung Electronics Co., Ltd., Suwon City, Kyungki-do (KR)
(72) Inventor: Shim, Se-jin, Guro-gu, Seoul (KR); Jin, You-chan, Paldal-gu, Suwon-city, Kyungki-do (KR); Nam, Seung-hee, Seocho-gu, Seoul (KR); Kang, Seung-dong, Guro-gu, Seoul (KR)
(74) Representative: Finnie, Peter John

(57) **Abstract**

In a warm wall type reaction chamber portion for forming an HSG silicon layer the temperature in the reaction chamber (46,50) is maintained at 200 ∼ 500°C, and an adiabatic unit is provided for preventing heat discharge from the reaction chamber. The warm wall reaction chamber can selectively form HSG on the surface of a storage electrode, and reduce the process time for forming the HSG silicon layer.

## Description

The present invention relates to a reaction chamber portion and a method for forming an HSG silicon layer using the same, and more particularly, to a warm wall type reaction chamber portion and a method for forming an HSG silicon layer using the same.

In general, for increasing capacitance of a capacitor, which is one component of a semiconductor device, there are methods of enlarging the area of an electrode of the capacitor, of reducing the thickness of a dielectric layer between electrodes, and of using a dielectric layer having a high dielectric constant. Here, in the case that the dielectric layer is thinned, leakage current is increased, which leads to a degradation of the characteristics of a capacitor. Therefore, a high dielectric film such as BST((Ba, Sr)TiO₃) and PZT(Pb(Zr, Ti)O₃) may be used. However, the high dielectric films have been of only partial use, and only in certain applications. Accordingly, in order to increase the capacitance of the capacitor, a cylindrical, stack- or fin-type capacitor electrode has been developed, instead of the conventional planar-type electrode. Here, a method for forming a hemi-spherical grain (HSG) silicon layer on an electrode surface of a capacitor is widely used, to increase the effective area of the electrode.

In order to selectively form the HSG silicon layer only on the electrode surface, there has been proposed a method using a cold wall type reaction chamber, having an excellent selectivity loss margin. The selectivity loss margin is the degree to which HSG silicon layer forms on an oxide layer, during forming HSG silicon layer on a silicon electrode.

An inner wall of the cold wall type reaction chamber is at a temperature of 10°C∼ 20°C, to prevent reaction gas from being adsorbed on the inner wall.

A conventional method for manufacturing a capacitor, in which an HSG silicon layer is formed on the surface of an electrode using the cold wall reaction chamber, will be described with reference to attached drawings.

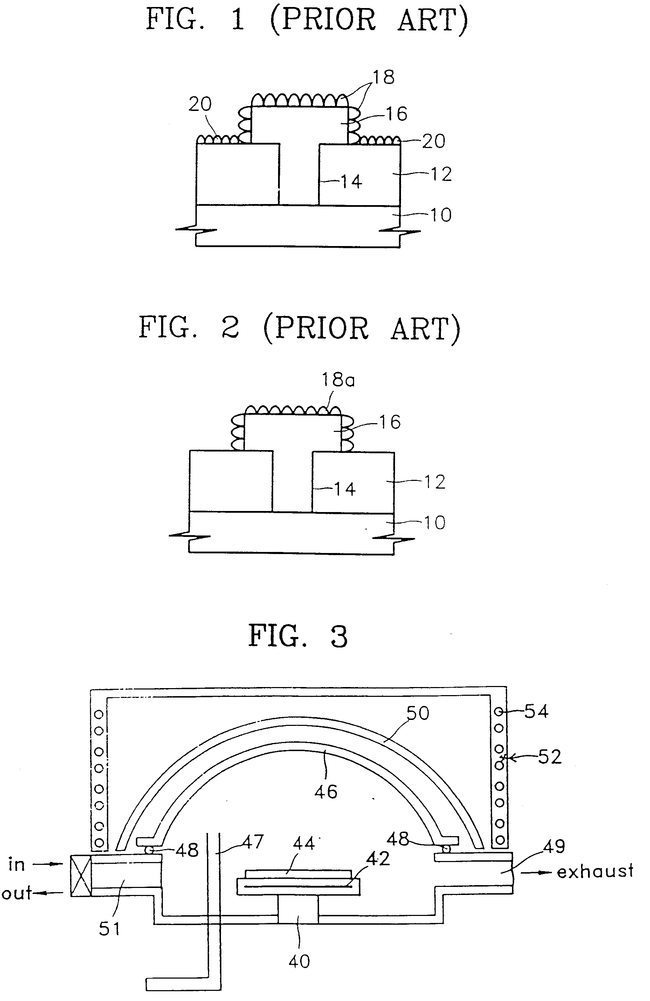

FIGS. 1 and 2 are views showing this conventional method for manufacturing a capacitor. In detail, as shown in FIG. 1, a gate electrode (not shown) is formed on a semiconductor substrate 10, and then a conductive impurity layer is formed on the substrate 10 using the gate electrode as a mask, to form a transistor. Subsequently, an interlayer dielectric film 12 is patterned to form a contact hole 14 for exposing part of the semiconductor substrate 10, on the entire surface of the semiconductor substrate 10 where the transistor is formed. The conductive material layer filling the contact hole 14 is formed on the entire surface of the interlayer dielectric film 12, and then the conductive material layer is patterned, to form a conductive layer pattern 16 corresponding to a storage node of a capacitor. The resultant structure is transferred to the cold wall reaction chamber, where an HSG silicon layer 18 is formed on the surface of the conductive layer pattern 16.

The cold wall type reaction chamber includes a susceptor whereon the semiconductor substrate 10 is loaded. The susceptor is heated to approximately 600°C before the substrate is loaded. This is a temperature appropriate for forming the HSG silicon layer.

The substrate 10 is loaded on the susceptor, and then reaction gas for forming an HSG seed is supplied into the reaction chamber during a process of stabilization. The reaction gas is one selected from the group consisting of silane SiH₄ and disilane Si₂H₆.

The HSG seeding is formed by the reaction gas, on the entire surface of the structure where the conductive layer pattern 16 is formed. Then, the HSG seed is grown through an annealing process to form an HSG silicon layer. Referring to FIG. 1, a first HSG silicon layer 18 is formed on the surface of the conductive layer pattern 16. A second HSG silicon layer 20, having a size smaller than that of the first HSG silicon layer 18, is formed on the entire surface of the interlayer dielectric film 12. It is preferable that the HSG silicon layer is formed only on the conductive layer pattern 16. Therefore, the entire surface of the resultant structure is etched back. As shown in FIG. 2, after the etchback, a first HSG silicon layer pattern 18a, having a unit area smaller than that of the first HSG silicon layer 18 formed on the side wall of the conductive layer pattern 16, is formed on the upper portion of the conductive layer pattern 16.

The conventional method for forming a capacitor having an HSG silicon layer includes an etch-back process, so that the surface area of the HSG silicon layer formed on a surface of the conductive layer pattern is reduced, which leads to a reduction in capacitance.

Meanwhile, cooling water flows in the inner wall of the cold wall type reaction chamber. Accordingly, when the reaction gas of the reaction chamber portion reaches the substrate, the temperature of the reaction gas is lower than that of the substrate. Therefore, a relatively long time is required to increase the temperature of the reaction gas to the temperature of the substrate to allow the reaction gas to react with the substrate. As a result, in the case that the HSG silicon layer is formed using the cold wall type reaction chamber, much time is required for forming the HSG.

According to a first aspect of the present invention, there is provided a reaction chamber comprising a susceptor where a heater for heating a substrate is installed, and an adiabatic unit surrounding a wall of the reaction chamber. At this time, the wall has a temperature of approximately 200 ∼ 500°C.

In one preferred embodiment of the present invention, the adiabatic unit is a silicon carbide heater having coils as a heat generator.

Preferably, the wall is a quartz tube and a silicon carbide tube surrounding the quartz tube.

Preferably, the reaction gas is one selected from a group consisting of SiH₄, Si₂H₆ and DCS which are gases for forming an HSG seed.

According to a second aspect of the present invention, there is provided a method for forming HSG of a semiconductor device which comprises the steps of:
a) forming a conductive layer pattern on a semiconductor substrate;
b) loading the resultant structure, where the conductive layer pattern is formed, into a warm wall type reaction chamber portion having a reaction chamber and an adiabatic unit surrounding the reaction chamber; and
c) forming an HSG silicon layer on the entire exposed surface of the conductive layer pattern.

Preferably, a reaction chamber having the adiabatic unit surrounding the wall of the reaction chamber is used as the warm wall type reaction chamber.

In the present invention, an HSG silicon layer without damage or defects can be formed on a lower electrode of the capacitor, and also, time for forming an HSG is reduced, to increase manufacturing productivity of a semiconductor device.

An example of the present invention will now be described in detail with reference to the accompanying drawings, in which:

FIGS. 1 and 2 are views sequentially showing a conventional method for fabricating a capacitor of a semiconductor device;

FIG. 3 is a sectional view of a warm wall type reaction chamber according to an embodiment of the present invention;

FIGS. 4 and 5 are views sequentially showing a method for manufacturing a capacitor of a semiconductor device using the warm wall type reaction chamber of FIG. 3;

FIG. 6 is a SEM phohotograph of an HSG silicon layer formed by the method for fabricating the capacitor of a semiconductor device using the warm wall type reaction chamber of FIG. 3; and

FIGS. 7 and 8 are graphs showing temperature change according to time during a process of forming an HSG silicon layer by a conventional art and according to the present invention, respectively.

The warm wall type reaction chamber portion shown in FIG. 3 includes a reaction chamber and an adiabatic unit surrounding the reaction chamber. The reaction chamber includes an inner wall formed of a quartz tube 46 and an outer wall formed of a silicon carbide tube 50. A susceptor 40 where a substrate 44 is mounted is located in the reaction chamber. A heater 42 for heating the substrate 44 is installed in the susceptor 40. A gas supply tube 47, through which reaction gas for forming an HSG silicon layer is supplied, is formed at the bottom left of the susceptor 40. Accordingly, the reaction gas flows into the reaction chamber. The reaction gas is for forming HSG silicon layer, and is at least one selected from the group consisting of silane (SiH₄), disilane (Si₂H₆) and Dichloro silane (DCS). An outlet 49 for discharging reacted gas in the reaction chamber is formed to the right side of the susceptor 40. Since the outlet 49 is connected to a pumping unit (not shown), the inside of the reaction chamber can be maintained at a desired pressure. Also, a load-lock chamber 51, for loading or unloading the substrate 44, is connected in one side of the reaction chamber portion, and the load-lock chamber 51 is connected to a transfer chamber (not shown). An O-ring 48 is installed between the quartz tube 46 and a lower structure with which the quartz tube 46 contacts. The adiabatic unit 52, surrounding the silicon carbide tube 50, has a heating coil 54 therein. The heating coil 54 constantly maintains the temperature of the inside of the reaction chamber.

A method, for fabricating a capacitor having an HSG silicon layer formed on an electrode surface, will be described using a warm wall type reaction chamber portion having the above structure.

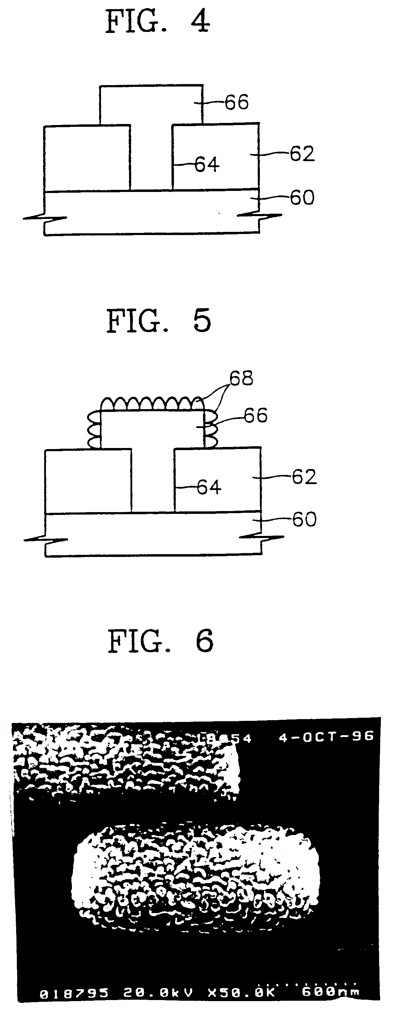

Referring to FIG. 4, a transistor(not shown) is formed on an active region of a semiconductor substrate 60. An interlayer dielectric film 62 is formed on the entire surface of the semiconductor substrate 60 where the transistor is formed, and patterned to form a contact hole 64 for partially exposing the semiconductor substrate 60. Subsequently, a conductive material layer for filling the contact hole 64 is formed on the entire surface of the interlayer dielectric film 62. The conductive material layer is formed of an amorphous silicon layer. The conductive material layer is patterned to form a conductive layer pattern 66 for filling the contact hole 64. Here, the conductive layer pattern 66 acts as a storage node of a capacitor.

FIG. 5 shows a step of forming an HSG silicon layer 68. In detail, the resultant structure where the conductive layer pattern 66 is formed is loaded into a warm wall type reaction chamber. Then, the HSG silicon layer 68 is formed on the surface of the conductive layer pattern 66. In the warm wall type reaction chamber, a selective deposition process is performed in which an HSG silicon layer is formed only on the silicon, to thereby form a uniform HSG silicon layer on the entire surface of the conductive layer pattern 66.

In detail, the semiconductor substrate 44 of FIG. 3 is the semiconductor substrate 60 where the conductive layer pattern 66 is formed, as shown in FIG. 4. The substrate 44, where the conductive layer pattern 60 is formed, is loaded on the susceptor 40, through the load-lock chamber 51 of the warm wall type reaction chamber portion having the above structure. Before the substrate 44 is loaded on the susceptor 40, the temperature of the susceptor 40 is maintained at 560 ∼ 630°C by a silicon carbide heater 42 installed in the susceptor 40. Accordingly, after the substrate 44 is loaded on the susceptor 40, the temperature of the substrate 44 matches that of the susceptor 40.

After the substrate 44 is loaded inside the reaction chamber, reaction gas is supplied into the reaction chamber through the gas supply tube 47, in such a state that temperatures of the quartz tube 46 and the silicon carbide tube 50 are maintained at 200 ∼ 500°C. The reaction gas for forming an HSG seed is one selected from the group consisting of silane, disilane and DCS.

While the reaction gas is supplied, the inside of the reaction chamber is maintained at a pressure of several millitorr to several tens of millitorr. Also, while the reaction gas flows in the reaction chamber, the silicon carbide tube 50 must be maintained at a temperature equal to that of the quartz tube 46. This is performed by installing a heater on each tube 46 and 50, or by using the tubes 46 and 50 formed of a black body, to thereby prevent heat of the reaction chamber from being discharged. Also, an adiabatic unit is formed surrounding the total external surface of the silicon carbide tube 50, to prevent heat loss from the reaction chamber, so that the inside of the reaction chamber is heated until the reaction gas injected into the reaction chamber reaches the substrate 44. The adiabatic unit 52 includes a silicon carbide heater for generating heat.

Subsequently, due to the reaction gas, an HSG silicon seed is formed on the substrate 44, and the seed is selectively formed only on the entire surface of the conductive layer pattern 66 formed of silicon layer. FIG. 6 is an SEM photograph of HSG silicon layer selectively formed on the entire surface of the conductive layer pattern 66.

Since the inside of the reaction chamber maintains at a temperature of 200 ∼ 500°C, the reaction gas is heated to the above temperature before it reaches the substrate 60. Accordingly, it takes less time, than that in the conventional cold wall type chamber, for the reaction gas to attain the temperature of the substrate 44, after it reaches the substrate 44 to form a seed. That is, time for temperature stabilization is very short.

The HSG silicon seed, formed on the entire surface of the conductive layer pattern 66, is grown through annealing to form an HSG silicon layer 68 on the entire surface of the conductive layer pattern 66, as shown in FIG. 5. According to the present invention, since the selective HSG silicon layer is formed by deposition, the HSG silicon layer 68 has little damage. As shown in FIG. 6, a uniform HSG silicon layer 68 is formed on the entire surface of the conductive layer pattern 66.

During annealing, pressure in the reaction chamber is maintained at 1 x 10⁻⁷ torr, which is lower than the pressure when the reaction gas is injected.

As described above, due to use of the pre-heated reaction gas, the period of time for the reaction gas to attain the temperature of the substrate 44 can be reduced.

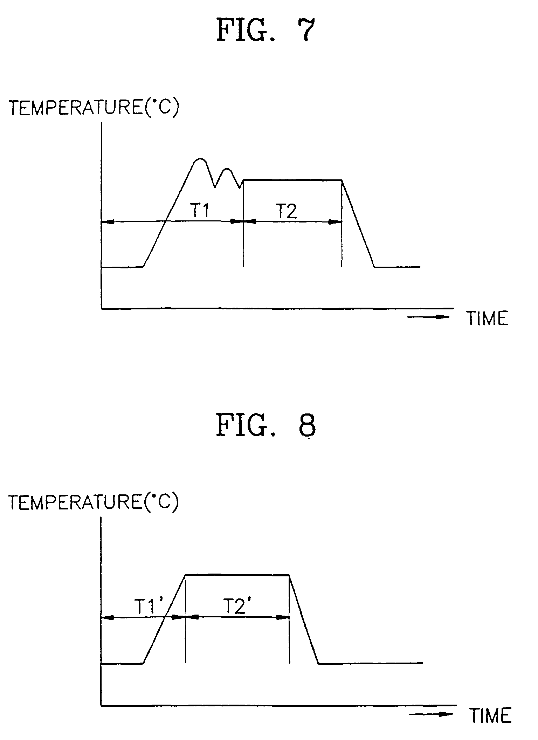

Referring to FIGS. 7 and 8, the times involved in forming an HSG silicon layer on a capacitor electrode will be compared and described, for when using reaction chambers of the conventional art and according to the present invention. The HSG silicon layer is formed by stabilizing the temperature of a substrate, supplying reaction gas into the reaction chamber to form an HSG silicon seed, and growing the HSG silicon seed.

In FIGS. 7 and 8, reference characters T1 and T1' indicate the time for stabilizing substrate temperature, by the conventional art and according to the present invention, respectively. Also, reference characters T2 and T2' indicate the time for seeding and annealing, by the conventional art and according to the present invention, respectively.

Referring to FIGS. 7 and 8, the time T1 for stabilizing a substrate in a conventional cold wall type reaction chamber is longer than the time T1' for a warm wall type reaction chamber portion according to the present invention. Also, by the conventional art, the temperature is unstable during the stabilization step.

In the warm wall type reaction chamber portion according to the present invention, the total time for the stabilizing process and forming the HSG silicon layer through annealing is approximately 8min, while it is 12min in the conventional cold wall type reaction chamber. Therefore, productivity is enhanced.

As described above, in the present invention the temperature in the reaction chamber is maintained at 200 ∼ 500°C, and an adiabatic unit is used for preventing heat discharge from the reaction chamber, to selectively form HSG on the surface of a storage electrode and reduce process time for forming the HSG silicon seed and the HSG silicon layer. Accordingly, productivity of manufacturing a semiconductor device having the HSG silicon layer can be enhanced.

## Claims

1. A warm wall type reaction chamber portion comprising:
a reaction chamber;
an adiabatic unit surrounding the reaction chamber; and
a susceptor (40) installed in the reaction chamber for mounting a semiconductor substrate (44).

2. The warm wall type reaction chamber portion of claim 1, wherein the reaction chamber includes an inner wall formed of quartz tubes (46) and an outer wall formed of silicon carbide tubes (50).

3. The warm wall type reaction chamber portion of claim 1 or 2, wherein the adiabatic unit includes a silicon carbide heater (44).

4. The warm wall type reaction chamber portion of claim 1, wherein the susceptor (40) includes a silicon carbide tube (50) therein.

5. The warm wall type reaction chamber portion of claim 2, wherein the inner wall (46) of the reaction chamber is a black body.

6. A method for forming an HSG silicon layer comprising the steps of:
a) forming a conductive layer pattern on a semiconductor substrate;
b) loading the resultant structure, where the conductive layer pattern is formed, into a warm wall type reaction chamber portion having a reaction chamber and an adiabatic unit surrounding the reaction chamber; and
c) forming an HSG silicon layer on the entire exposed surface of the conductive layer pattern.

7. The method for forming an HSG silicon layer of claim 6, wherein the conductive layer pattern is formed of an amorphous silicon layer.

8. The method for forming an HSG silicon layer of claim 6 or 7, the step c) comprising steps of:
c1) heating, for stabilizing the substrate to a constant temperature;
c2) injecting reaction gas into the pre-heated reaction chamber, to selectively form an HSG silicon seed on the conductive layer pattern; and
c3) growing the HSG silicon seed.

9. The method for forming an HSG silicon layer of any of claims 6 to 8, wherein the substrate is held at a temperature of 560 ∼ 630°C.

10. The method for forming an HSG silicon layer of claim 8, wherein during step c2) of injecting the reaction gas, the inside of the reaction chamber is maintained at a pressure of several millitorr to several tens of millitorr.

11. The method for forming an HSG silicon layer of claim 8, wherein the step c3) of growing the HSG silicon seed is performed under a pressure of 1 x 10⁻⁹ torr.

12. The method for forming an HSG silicon layer of claim 10, wherein the reaction gas is one selected from the group consisting of silane (SiH₄), disilane (Si₂H₆) and DCS.

13. The method for forming an HSG silicon layer of claim 6, wherein the reaction chamber is formed to be a black body.

14. The method for forming an HSG silicon layer of claim 6, wherein the adiabatic unit includes a silicon carbide (SiC) heater.
